# FASCICULE DE BREVET EUROPEEN

(11) **EP 0 410 908 B1**
(45) Date de publication et mention de la délivrance du brevet: **23.03.1994**
(21) Numéro de dépôt: 90420352.8
(22) Date de dépôt: 23.07.1990
(51) Int. Cl.: H03K 17/693

(54) **Point de croisement pour matrice de commutation**
Koppelpunkt für Schaltmatrix
Cross-point for switching matrix

(30) Priorité: 27.07.1989 FR 8910384
(43) Date de publication de la demande: 30.01.1991
(73) Titulaire: SGS-THOMSON MICROELECTRONICS S.A., 94250 Gentilly (FR)
(72) Inventeur: Harrand, Michel, F-38120 Saint Egrève (FR)
(74) Mandataire: de Beaumont, Michel

(56) Documents cités:
- IEEE JOURNAL OF SELECTED AREAS IN COMMUNICATIONS, vol. SAC-5, no. 8, octobre 1987, pages 1231-1241, IEEE, New York, US; G. HAYWARD et al.: "CMOS VLSI applications in broadband circuit switching"
- 1986 IEEE INTERNATIONAL SOLID-STATE CIRCUITS CONFERENCE, DIGEST OF TECHNICAL PAPERS, février 1986, session XI:D/A and A/D Converters, pages 130-131, IEEE, New York, US; J.W. SCOTT et al.: "A CMOS slope adaptive delta modulator"

## Description

La présente invention concerne une matrice de commutation et plus particulièrement une matrice de commutation numérique large bande pouvant fonctionner à des cadences très élevées, supérieures à 100 mégabits par seconde, utilisable par exemple pour la commutation de canaux de télévision numériques.

Une matrice de commutation est un circuit possédant n canaux d'entrée et m canaux de sortie et permettant d'appliquer indépendamment sur chacun des m canaux de sortie l'un quelconque des n canaux d'entrée (ou son complément). Chaque canal d'entrée peut être connecté à un nombre quelconque de sorties. Par contre, un canal de sortie ne peut être relié qu'à un seul canal d'entrée.

Pour la réalisation d'une telle matrice de commutation, on cherche à obtenir les objectifs suivants :
- fréquence de fonctionnement élevée ou temps de propagation faible selon l'application (système asynchrone ou synchrone),
- faible consommation,
- faible taux de diaphonie,
- faible encombrement du circuit lors de sa réalisation sur une plaquette de silicium.

Dans l'état actuel de la technique, pour atteindre les fréquences de fonctionnement très élevées susmentionnées, on pense d'abord à utiliser une technologie bipolaire, par exemple de type ECL, qui permet d'atteindre de telles fréquences. Toutefois, avec une telle technologie, la surface du circuit est de façon inévitable importante de même que sa consommation.

Ainsi, on a cherché dans la technique divers moyens pour réaliser de tels circuits en utilisant une technologie de type CMOS, c'est-à-dire une technologie comprenant des transistors MOS à canal N et à canal P : en effet, on sait a priori qu'une telle technologie permettrait de réduire la consommation et la surface du circuit. Toutefois, les réalisations actuelles de points de commutation à partir de transistors CMOS présentent, d'une part l'inconvénient d'un défaut de rapidité, d'autre part l'inconvénient de ne pas être compatible en ce qui concerne leur tension de commande avec les circuits voisins de traitement de signaux haute fréquence qui sont généralement réalisés en technologie ECL.

Les transistors MOS ont généralement besoin pour leur commande d'une différence entre un niveau haut et un niveau bas de plusieurs volts alors que les niveaux de commande en ECL varient de quelques centaines de millivolts. Ainsi, pour résoudre ce problème de compatibilité, on est amené à prévoir des circuits de conversion de niveaux de commande ECL en niveaux de commande CMOS et de niveaux de commande CMOS en niveaux de commande ECL, ce qui présente l'inconvénient, d'une part, de nécessiter une surface importante et donc d'annuler ainsi une partie des avantages recherchés par une technologie CMOS et, d'autre part, d'ajouter un temps de propagation important aux signaux, ce qui est particulièrement gênant dans le cas de la transmission de signaux en mode synchrone.

En outre, le fait d'utiliser pour la commande des transistors MOS des niveaux logiques présentant un écart important entraîne que les temps de commutation sont nécessairement longs puisqu'il faut charger des capacités d'entrée de ces transistors MOS et que la durée de charge (dt) est directement proportionnelle à la différence de tension (dV) entre les niveaux haut et bas (dT = CdV/i) pour les charges capacitives que constituent les grilles des transistors MOS.

Un exemple de réalisation de point de croisement à transistors MOS est donné dans l'article de Hyun J. Shin et David A. Hodges paru dans IEEE Journal of Solid State Circuits, volume 24, N° 2, Avril 1988, intitulé "A 250-Mbit/s CMOS Crosspoint Switch". Dans cet article, une partie des problèmes liés à l'utilisation des transistors MOS est résolue en ce qui concerne l'excursion en sortie des signaux de commande. Par utilisation d'un amplificateur de sortie particulier représenté en figure 7, page 482, de cet article, l'excursion de tension en sortie est limitée et est compatible ECL. Toutefois, le problème de la commande d'entrée des transistors MOS n'est pas résolu et, comme le représente la figure 8 de cet article, on utilise pour chaque ligne de la matrice un tampon d'entrée permettant notamment de convertir des signaux logiques ECL en signaux logiques CMOS.

Un objet de la présente invention est de prévoir un point de croisement pour une matrice de commutation permettant de résoudre complètement les problèmes susmentionnés de compatibilité ECL/CMOS et de rapidité de fonctionnement.

Pour atteindre ces objets ainsi que d'autres, la présente invention prévoit un point de croisement pour une matrice de commutation à n lignes (rangées) d'entrée et m lignes (colonnes) de sortie, chaque ligne comprenant une paire différentielle de conducteurs, ce point de croisement étant constitué de transistors MOS à enrichissement à canal P et à canal N. Dans ce point de croisement :
- chaque conducteur de ligne d'entrée est connecté à une entrée d'un premier amplificateur différentiel dont chaque branche est associée par un montage en miroir de courant à une première source de courant validée par une entrée de sélection du point de croisement,
- les sorties du premier amplificateur différentiel sont reliées à une paire différentielle de transistors MOS alimentés par une deuxième source de courant commune à tous les points de croisement d'une même colonne, et
- les sorties de la paire différentielle sont reliées à la paire de conducteurs d'une colonne de sortie, une extrémité de cette colonne étant reliée à la source de tension haute par l'intermédiaire d'une résistance.

Selon un mode de réalisation de la présente invention, il est prévu des moyens pour bloquer les transistors de la paire différentielle quand le point mémoire n'est pas sélectionné.

Selon un mode de réalisation de la présente invention, l'amplificateur différentiel comprend, en parallèle, deux branches constituées respectivement d'un premier transistor à canal P et d'un premier transistor à canal N et d'un deuxième transistor à canal P et d'un deuxième transistor à canal N, les drains des transistors à canal P étant reliés à une source d'alimentation haute et les sources des premier et deuxième transistors à canal N étant reliées à une borne d'alimentation basse par l'intermédiaire d'un troisième transistor MOS à canal N ladite source de courant comprenant entre la source d'alimentation haute et la source d'alimentation basse le montage en série d'un troisième transistor à canal P dont le drain est connecté à la grille, d'un quatrième transistor à canal N dont la grille reçoit le signal de sélection du point de croisement, et d'un cinquième transistor à canal N dont le drain est relié à la grille ; le montage en miroir de courant étant assuré par l'interconnexion des grilles des premier, deuxième et troisième transistors à canal P et par l'interconnexion des grilles des troisième et cinquième transistors à canal N ; les grilles des premier et deuxième transistors à canal N étant respectivement reliées à chacun des conducteurs du canal d'entrée et les drains de ces transistors étant respectivement reliés aux grilles de commande de la paire différentielle.

Selon un mode de réalisation de la présente invention, les moyens de blocage comprennent un sixième transistor à canal N relié en parallèle sur le troisième transistor à canal N et recevant l'inverse du signal de sélection.

Selon un mode de réalisation de la présente invention, chaque colonne comprend, en série avec chaque résistance, un transistor bipolaire dont le collecteur est relié à la résistance, dont l'émetteur est relié à la colonne et dont la base est reliée à la source d'alimentation haute, la colonne étant reliée à une troisième source de courant.

Ces objets, caractéristiques et avantages ainsi que d'autres de la présente invention seront exposés plus en détail dans la description suivante de modes de réalisation particuliers faite en relation avec les figures jointes, parmi lesquelles :
La figure 1 représente de façon générale et schématique une matrice de commutation ;
La figure 2 représente les éléments de base d'un point de croisement CMOS selon l'art antérieur ;
La figure 3 représente un point de croisement selon la présente invention ; et
la figure 4 illustre une variante de réalisation applicable à la présente invention.

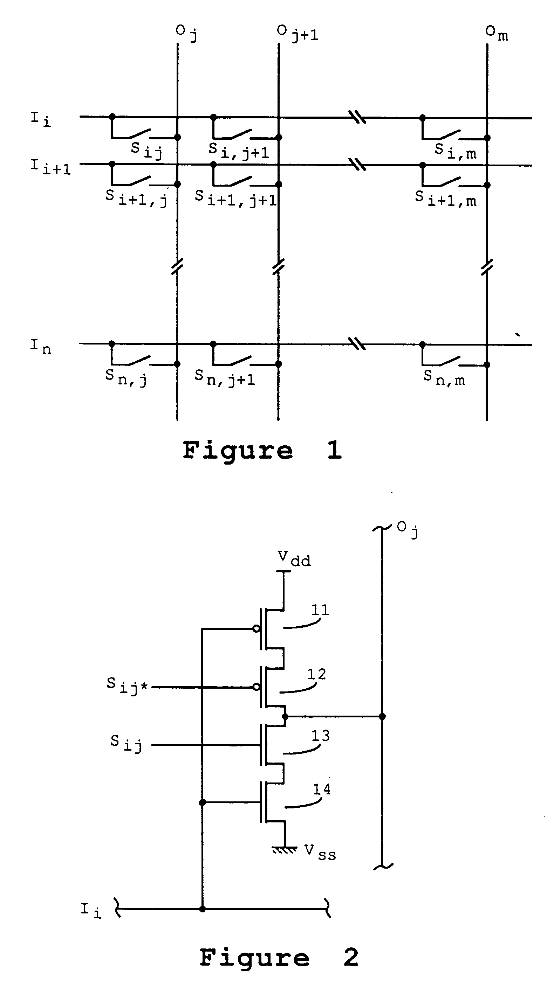

Comme le représente la figure 1, une matrice de commutation est destinée à établir des connexions entre des lignes d'entrée I1 ... Ii ... In et certaines choisies de lignes de sortie O1 ... Oj ... Om, les connexions étant déterminées par des signaux de sélection Sij commandant des commutateurs placés aux points de croisement de chaque ligne et de chaque colonne (les signaux de sélection proviennent généralement d'une mémoire). On s'intéresse ici au cas particulier où une colonne doit être reliée au plus à une rangée (mais où une même rangée peut être reliée à plusieurs colonnes).

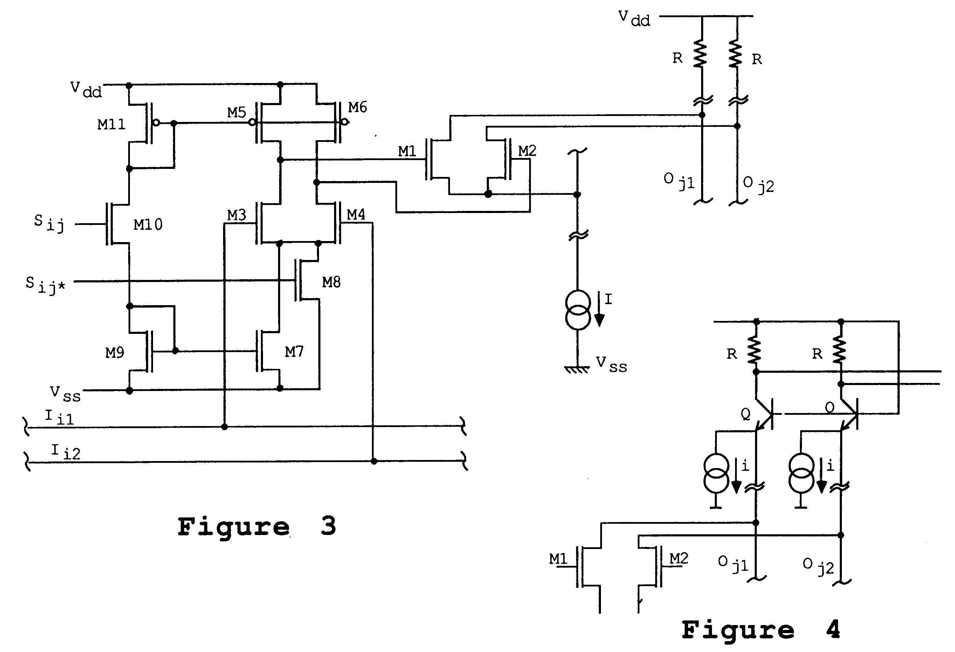

Un exemple de réalisation classique de points de croisement réalisés en technologie CMOS est illustré en figure 2 et correspond par exemple à une partie du point de croisement décrit dans l'article sus-mentionné. Dans la figure 2, apparaît une partie d'une rangée Ii et une partie d'une colonne Oj. Entre une source de tension haute Vdd et une source de tension basse Vss sont connectés en série quatre transistors MOS à enrichissement, à savoir successivement : deux transistors MOS à canal P 11 et 12 et deux transistors MOS à canal N 13 et 14. Les grilles des transistors MOS 11 et 14 sont reliées à la rangée Ii. La grille du transistor MOS à canal N 13 est connectée au signal de sélection Sij et la grille du transistor MOS à canal P 12 est reliée au complément Sij* du signal de sélection Sij. Ainsi, si Sij est à bas niveau, les transistors 12 et 13 sont bloqués et le point de connexion est inhibé. Si Sij est à 1, les transistors 12 et 13 sont conducteurs et l'on retrouve sur la ligne Oj le complément du signal Ii (Vdd si Ii est à bas niveau et Vss si Ii est à haut niveau).

Les inconvénients d'un tel circuit ont été mentionnés précédemment. On notera que l'amélioration apportée par le document susmentionné à ce circuit consiste à ajouter derrière la ligne Oj un circuit d'amplification et de limitation d'amplitude des signaux sur cette ligne.

La figure 3 illustre schématiquement un mode de réalisation d'un circuit selon la présente invention. On peut y voir un canal d'entrée Ii réalisé sous forme de deux conducteurs différentiels Ii1 et Ii2, et un canal de sortie constitué d'une paire de conducteurs différentiels Oj1 et Oj2. Les colonnes, c'est-à-dire les conducteurs Oj1 et Oj2, sont connectées à la source de tension haute Vdd par l'intermédiaire de résistances R. Ainsi, si un courant I est extrait sur l'un des conducteurs Oj1 ou Oj2, la tension sur ce conducteur chute à une valeur Vdd - RI, alors que l'autre conducteur est à la tension Vdd. En choisissant convenablement les valeurs de R et de I, on pourra donc obtenir sur ces lignes des niveaux compatibles ECL.

Le point de croisement comprend un étage de sortie constitué d'une paire différentielle de transistors MOS à canal N, M1 et M2. Les drains de ces transistors sont connectés à chacune des colonnes Oj1 et Oj2 et les sources de ces transistors sont connectées ensemble à une colonne supplémentaire reliée à la tension d'alimentation basse Vss par l'intermédiaire d'une source de courant I. Ainsi, selon le transistor M1 ou M2 qui est passant, la ligne Oj1 ou Oj2 sera au niveau logique bas. On notera que la source de courant I est commune à tous les points de croisement d'une même colonne, de même que les résistances R.

Les grilles des transistors M1 et M2 de l'étage de sortie sont attaquées par un étage différentiel comprenant des transistors MOS à canal N, M3 et M4, dont les sources sont interconnectées et dont les grilles sont respectivement reliées aux conducteurs Ii1 et Ii2 du canal d'entrée Ii. Les drains des transistors M3 et M4 sont reliés à la source de tension haute Vdd par des transistors MOS à canal P M5 et M6 et la source commune des transistors M3 et M4 est reliée à la source d'alimentation basse Vss par un transistor MOS à canal N, M7, disposé en parallèle avec un transistor MOS à canal N, M8, dont la grille reçoit le complément Sij* du signal de sélection de ce point de croisement.

Le point de croisement comprend également, entre la source d'alimentation basse Vss et la source d'alimentation haute Vdd, un transistor MOS à canal N, M9, un transistor MOS à canal N, M10, et un transistor MOS à canal P, M11. La grille du transistor M9 est reliée à son drain et la grille du transistor M11 est reliée à son drain. La grille du transistor M10 reçoit le signal de sélection Sij. Ainsi, quand le point de croisement ij est sélectionné, c'est-à-dire que le signal Sij est à 1, l'ensemble des transistors M9, M10 et M11 constitue une source de courant constant, sensiblement indépendante des dispersions de caractéristiques résultant du procédé de fabrication des transistors à canal N et à canal P.

Les transistors M5 et M6 ont leur grille reliée à la grille du transistor M11 et le transistor M7 a sa grille reliée à la grille du transistor M9. Ainsi, les transistors M5 et M6 forment avec le transistor M11 un miroir de courant, de même que le transistor M7 avec le transistor M9.

Le fonctionnement de ce point de croisement est le suivant.

Quant le signal Sij est à haut niveau, c'est-à-dire que le point de croisement est sélectionné, le transistor M10 est passant et le transistor M8 est bloqué. Celui des conducteurs Ii1 ou Ii2 qui est au niveau le plus élevé détermine que le transistor M3 ou M4 est passant, et il circulera alors dans la branche M5-M3-M7 ou dans la branche M6-M4-M7 un courant égal à celui déterminé par la source de courant M9-M10-M11, l'autre des branches étant bloquée. Il en résulte la mise en conduction de l'un ou l'autre des transistors M1 ou M2 de l'étage de sortie et donc le changement d'état de l'un ou l'autre des conducteurs de sortie de colonne Oj1 ou Oj2. On notera que, si l'on excepte les signaux de sélection, tous les autres signaux entraînent le fonctionnement du point de croisement s'ils présentent une différence de niveau qui est seulement de l'ordre de quelques centaines de millivolts, ce qui est compatible avec les niveaux nécessaires au fonctionnement d'un circuit de type ECL.

Par contre, si le signal Sij est à bas niveau pour inhiber le point de croisement, aucun courant ne circule dans la source de courant M9-M10-M11, les transistors M5, M6 et M7 sont bloqués et le transistor M8 devient passant, amenant au potentiel bas (Vss) les sources des transistors M3 et M4 ainsi que leurs drains puisque ces transistors restent relativement passants. Il en résulte que les transistors M1 et M2 sont bloqués et qu'aucun courant n'est extrait des conducteurs de sortie Oj1 et Oj2 par la source de courant I.

On notera qu'un des avantages de la présente invention est que la charge des signaux d'entrée est indépendante de l'état (sélectionné ou non) des commutateurs. Le fait de changer de sélection sur le canal de sortie n'a donc pas d'effet indésirable sur les autres. Il en résulte que le temps de propagation des signaux est sensiblement constant et que l'on évite l'apparition de phénomènes de diaphonie qui seraient liés à des fluctuations des alimentations.

Bien entendu, la présente invention est susceptible de nombreuses variantes qui apparaîtront à l'homme de l'art.

La figure 4 illustre un exemple d'une telle variante dans laquelle ont été rajoutés sur les colonnes de sortie Oj des transistors bipolaires Q de type NPN dont le collecteur est relié aux résistances R et l'émetteur à la colonne respective Oj1, Oj2. Ces émetteurs sont également reliés à des sources de courant i. Ceci permet de maintenir à un potentiel constant les drains des transistors M1 et M2. En ce cas, la sortie de la colonne est prise sur les collecteurs des transistors Q. Du fait de la constance des potentiels sur les drains des transistors M1 et M2, et aussi sur leurs sources, les capacités sur les lignes Oj1 et Oj2 n'ont pratiquement aucune influence sur la rapidité du circuit.

## Revendications

1. Point de croisement pour une matrice de commutation à n lignes d'entrée et m colonnes de sortie, chaque ligne et chaque colonne comprenant une paire différentielle de conducteurs, ce point de croisement étant constitué de transistors MOS à enrichissement à canal P et à canal N, et étant caractérisé en ce que:
- chaque conducteur (Ii1, Ii2) de ligne d'entrée est connecté à une entrée d'un premier amplificateur différentiel (M3, M4) dont chaque branche est associée par un montage en miroir de courant à une première source de courant (M9, M10, M11) validée par une entrée de sélection (Sij) du point de croisement,
- les sorties du premier amplificateur différentiel sont reliées à une paire différentielle de transistors MOS (M1, M2) alimentés par une deuxième source de courant (I) commune à tous les points de croisement d'une même colonne, et
- les sorties de la paire différentielle sont reliées à la paire de conducteurs (Oj1, Oj2) d'une colonne de sortie, chaque conducteur étant relié à une source d'alimentation haute (Vdd) par l'intermédiaire d'une résistance (R).

2. Point de croisement selon la revendication 1, caractérisé en ce que le premier amplificateur différentiel comprend des moyens (M8, Sij*) pour bloquer les transistors de la paire différentielle quand le point mémoire n'est pas sélectionné.

3. Point de croisement selon la revendication 1, caractérisé en ce que ledit amplificateur différentiel comprend, en parallèle, deux branches constituées respectivement d'un premier transistor à canal P (M5) et d'un premier transistor à canal N (M3) et d'un deuxième transistor à canal P (M6) et d'un deuxième transistor à canal N (M4), les drains des transistors à canal P étant reliés à la source d'alimentation haute (Vdd) et les sources des premier et deuxième transistors à canal N étant reliées à une borne d'alimentation basse (Vss) par l'intermédiaire d'un troisième transistor MOS à canal N (M7), ladite source de courant comprenant entre la source d'alimentation haute et la source d'alimentation basse le montage en série d'un troisième transistor à canal P (M11) dont le drain est connecté à la grille, d'un quatrième transistor à canal N (M10) dont la grille reçoit le signal de sélection (Sij) du point de croisement, et d'un cinquième transistor à canal N (M9) dont le drain est relié à la grille ; le montage en miroir de courant étant assuré par l'interconnexion des grilles des premier, deuxième et troisième transistors à canal P et par l'interconnexion des grilles des troisième et cinquième transistors à canal N ; les grilles des premier et deuxième transistors à canal N étant respectivement reliées à chacun des conducteurs du canal d'entrée et les drains de ces transistors étant respectivement reliés aux grilles de commande de la paire différentielle (M1, M2).

4. Point de croisement selon les revendications 2 et 3, caractérisé en ce que les moyens de blocage comprennent un sixième transistor à canal N (M8) relié en parallèle sur le troisième transistor à canal N (M7) et recevant l'inverse du signal de sélection (Sij*).

5. Point de croisement selon la revendication 1, caractérisé en ce que chaque colonne comprend, en série avec chaque résistance (R), un transistor bipolaire (Q) dont le collecteur est relié à la résistance, dont l'émetteur est relié à un conducteur de colonne et dont la base est reliée à la source d'alimentation haute, chaque conducteur de colonne étant relié à une troisième source de courant (i).

## Claims

1. A crosspoint for a switching matrix having n input lines and m output columns, each line and each column comprising a differential pair of conductors, this cross-point being constituted by enhanced P-channel and N-channel MOS transistors, characterized in that:
- each input line conductor (Ii1 and Ii2) is connected to an input of a first differential amplifier (M3, M4), each leg of which is associated by a current mirror circuit to a first current source (M9, M10, M11) enabled by a selection input (Sij) of the crosspoint,
- the outputs of the first differential amplifier are connected to a differential pair of MOS transistors (M1, M2) fed by a second current source (I) common to all the crosspoints of a same column, and
- the outputs of the differential pair are connected to the pair of conductors (0j1, 0j2) of an output column, each conductor being connected to a high supply source (Vdd) through a resistor (R).

2. A crosspoint according to claim 1, characterized in that the first differential amplifier comprises means (M8, Sij*) for turning off the transistors of the differential pair when the memory point is not selected.

3. A crosspoint according to claim 1, characterized in that said differential amplifier comprises, in parallel, two legs respectively constituted by a first P-channel transistor (M5) and a first N-channel transistor (M3), and by a second P-channel transistor (M6) and a second N-channel transistor (M4), the drains of the P-channel transistors being connected to the high supply source (Vdd) and the sources of the first and second N-channel transistors being connected to a low supply terminal (Vss) through a third N-channel MOS transistor (M7), said current source comprising between the high supply source and the low supply source a structure in series of a third P-channel transistor (M11), the drain of which is connected to the gate, a fourth N-channel transistor (M10), the gate of which receives the selection signal (Sij) of the crosspoint, and a fifth N-channel transistor (M9), the drain of which is connected to the gate; the current mirror circuit being implemented by the gate interconnection of the first, second and third P-channel transistors and through the gate interconnection of the third and fifth N-channel transistors; the gates of the first and second N-channel transistors being respectively connected to each input channel conductor and the drains of those transistors being respectively connected to the control gates of the differential pair (M1, M2).

4. A crosspoint according to claims 2 and 3, characterized in that the means for turning off comprise a sixth N-channel transistor (M8) connected in parallel to the third N-channel transistor (M7) and receiving the reverse selection signal (Sij*).

5. A crosspoint according to claim 1, characterized in that each column comprises, in series with each resistor (R), a bipolar transistor (Q), the collector of which is connected to the resistor, the emitter is connected to a column conductor and the base is connected to the high supply source, each column conductor being connected to a third current source (i).

## Patentansprüche

1. Koppelpunkt für eine Schaltmatrix mit n Eingangszeilen und m Ausgangsspalten, bei der jede Zeile und jede Spalte ein differentielles Leiterpaar umfaßt, wobei der Koppelpunkt aus Anreicherungs-P-Kanal- und N-Kanal-MOS-Transistoren aufgebaut ist und dadurch gekennzeichnet ist, daß
- jeder Leiter (Ii1, Ii2) der Eingangszeile mit einem Eingang eines ersten Differentialverstärkers (M3, M4) verbunden ist, bei dem jeder Zweig über eine Stromspiegelschaltung mit einer ersten Stromquelle (M9, M10, M11) verbunden ist, welche durch einen Auswahleingang (Sij) des Koppelpunkts gesetzt wird,
- die Ausgänge des ersten Differentialverstärkers mit einem differentiellen Paar von MOS-Transistoren (M1, M2) verbunden sind, welche durch eine zweite Stromquelle (I) versorgt werden, welche allen Koppelpunkten derselben Spalte gemeinsam ist, und
- die Ausgänge des differentiellen Paars mit dem Leiterpaar (Oj1, Oj2) einer Ausgangsspalte verbunden sind, wobei jeder Leiter mit einer Quelle hoher Versorgung (Vdd) über einen Widerstand (R) verbunden ist.

2. Koppelpunkt nach Anspruch 1, dadurch gekennzeichnet, daß der erste Differentialverstärker eine Einrichtung (M8, Sij*) zum Blockieren der Transistoren des differentiellen Paars umfaßt, wenn der Speicherpunkt nicht gewählt ist.

3. Koppelpunkt nach Anspruch 1, dadurch gekennzeichnet, daß der Differentialverstärker zwei parallele Zweige umfaßt, welche von einem ersten P-Kanal-Transistor (M5) und einem ersten N-Kanal-Transistor (M3) bzw. einem zweiten P-Kanal-Transistor (M6) und einem zweiten N-Kanal-Transistor (M4) gebildet werden, wobei die Drains der P-Kanal-Transistoren mit der Quelle hoher Versorgung (Vdd) verbunden sind und die Sources des ersten und zweiten N-Kanal-Transistors mit einem Anschluß einer niedrigen Versorgung (Vss) über einen dritten N-Kanal-MOS-Transistor (M7) verbunden sind, wobei die Stromquelle zwischen der Quelle hoher Versorgung und der Quelle niedriger Versorgung eine Reihenschaltung eines dritten P-Kanal-Transistors (M11), dessen Drain mit dem Gate verbunden ist, eines vierten N-Kanal-Transistors (M10), dessen Gate das Auswahlsignal (Sij) des Koppelpunkts empfängt, und eines fünften N-Kanal-Transistors (M9), dessen Drain mit dem Gate verbunden ist, umfaßt, wobei die Stromspiegelschaltung durch das Verbinden der Gates des ersten, zweiten und dritten P-Kanal-Transistors und durch das Verbinden der Gates des dritten und fünften N-Kanal-Transistors gebildet wird, und wobei die Gates des ersten und zweiten N-Kanal-Transistors jeweils mit einem der Eingangskanalleiter verbunden sind und die Drains dieser Transistoren jeweils mit den Steuer-Gates des differentiellen Paars (M1, M2) verbunden sind.

4. Koppelpunkt nach den Ansprüchen 2 und 3, dadurch gekennzeichnet, daß die Blockiereinrichtung einen sechsten N-Kanal-Transistor (M8) umfaßt, welcher parallel zu dem dritten N-Kanal-Transistor (M7) geschaltet ist und das inverse Auswahlsignal (Sij*) empfängt.

5. Koppelpunkt nach Anspruch 1, dadurch gekennzeichnet, daß jede Spalte einen Bipolartransistor (Q) in Reihe mit jedem Widerstand (R) umfaßt, dessen Kollektor mit dem Widerstand verbunden ist, dessen Emitter mit einem Spaltenleiter verbunden ist und dessen Basis mit der Quelle hoher Versorgung verbunden ist, wobei jeder Spaltenleiter mit einer dritten Stromquelle (i) verbunden ist.
